**Europäisches Patentamt**

**European Patent Office**

**Office européen des brevets**

(19)

(11) Veröffentlichungsnummer : **0 274 474 B1**

(12) # EUROPÄISCHE PATENTSCHRIFT

(45) Veröffentlichungstag der Patentschrift :
**04.03.92 Patentblatt 92/10**

(51) Int. Cl.$^5$ : **H03H 17/02**

(21) Anmeldenummer : **87900066.9**

(22) Anmeldetag : **24.12.86**

(86) Internationale Anmeldenummer :
**PCT/DE86/00524**

(87) Internationale Veröffentlichungsnummer :
**WO 87/06075 08.10.87 Gazette 87/22**

(54) **DIGITALE FILTERBANK.**

(30) Priorität : **26.03.86 DE 3610195**

(43) Veröffentlichungstag der Anmeldung :
**20.07.88 Patentblatt 88/29**

(45) Bekanntmachung des Hinweises auf die
Patenterteilung :
**04.03.92 Patentblatt 92/10**

(84) Benannte Vertragsstaaten :
**FR GB IT NL SE**

(56) Entgegenhaltungen :
**US-A- 4 131 766**
**Proceedings of the IEEE vol 69, no 11 November 1981 New york US H SCHEURMANN et al : " A Comprehensive survey of digital transmultiplexing methods", pages 1419-1450 see the whole document cited in the application.**

(56) Entgegenhaltungen :
**NACHRICHTENTECHNISCHE ZEITSCHRIFT, vol 27, no. 11, November 1974 Berlin Germany. W Schaller , " Verwendung der schnellen Fouriertansformationen in Digitalen filtern", pages 425-431. see the whole document. 1978, IEEE Int. conf. on Acoustics, speech and signal processing, 10-12 April 1978, Tulsa Oklahoma US. M.J. Narasima et al.: Design and applications of uniform digital bandpass filterbanks, pages 499-503, see the whole document**

(73) Patentinhaber : **ANT Nachrichtentechnik GmbH**
**Gerberstrasse 33**
**W-7150 Backnang (DE)**

(72) Erfinder : **GÖCKLER, Heinz**
**Elbinger Strasse 52**
**W-7150 Backnang (DE)**

EP 0 274 474 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung bezieht sich auf eine digitale Filterbank gemäß Oberbegriff des Anspruches 1.bzw. des Anspruches 8. Solche digitalen Filterbänke werden eingesetzt zum Demultiplexen und Multiplexen digitalisierter Frequenzmultiplexsignale. Sie sind bekannt beispielsweise durch den Aufsatz von F.M. Gardener "Onboard processing for mobile-satellite communications" in Final report: ESTEC Contract 5889/84 Palo Alto, Californien, Gardener Research Company, 2. Mai 1985 und durch den Aufsatz "Comprehensive survey of digital transmultiplexing message" von Helmut Scheuermann und Heinz Göckler, Proceedings of the IEEE 69 vom November 1981, S. 1419 bis 1450.

In der US-A 4,131,766 ist eine digitale Filterbank beschrieben zur Modulation und Demodulation in FDM-Systemen, wobei zur Modulation eine diskrete Fourier-Transformation für Datenabtastwerte im TDM-Format und eine Wichtung mit vorbestimmten Koeffizienten zur Bildung eines FDM-Signals und zur Demodulation ebenfalls eine Wichtung mit anschließender erneuter DFT zur Bildung eines TDM-Signals durchgeführt werden.

Nachteilig ist bei den bekannten digitalen Filterbänken, daß die FFT-Algorithmen, die an die Verarbeitung komplexer Signale angepaßt sind, nicht optimal eingesetzt werden können.

Der vorliegenden Erfindung lag deshalb die Aufgabe zugrunde, eine digitale Filterbank der eingangs gennanten Art anzugeben, welche Filterbank eine optimale Ausnutzung der FFT-Algorithmen erlaubt.

Diese Aufgabe wurde gelöst durch die kennzeichnenden Merkmale der Patentansprüche 1 bzw. 8.

Optimale Ausgestaltungen der Erfindung ergeben sich durch die Unteransprüche.

Durch die vorgeschlagene Filterbank ergibt sich ein optimaler Einsatz von FFT-Algorithmen. Die digitalen Filterbänke gemäß der Erfindung sind sehr effizient, d.h. sie benötigen im Hinblick auf die gestellten Aufgaben und Forderungen bezüglich Steilheit, Durchlaß- und Sperrippel usw. wenig Addierer und Multiplizierer.

Es folgt nun die Beschreibung der Erfindung anhand der Figuren.

In Figur 1 ist ein Blockschaltbild für die digitale Filterbank gemäß Figur 2 gezeichnet, welche ein Übersichtsschaltbild zeigt.

Die Figur 3 zeigt eine Schaltungsanordnung eines Teils der digitaler Filterbank in detaillierter Form.

In Figur 4 sind einige Frequenzspektren wiedergegeben, wie sie bei der Signalverarbeitung gemäß der digitalen Filterbank entstehen.

Die Figuren 5, 6 und 7 zeigen besonders günstige Realisierungsformen entsprechend Figur 3 der digitalen Filterbank. In Figur 8 ist eine hierarchische Mehrstufen-Baumstruktur mit mehreren digitalen Filterbänken gezeichnet.

Die Figur 9 schließlich zeigt eine besonders günstige optimale Schaltungsanordnung einer digitalen Filterbank.

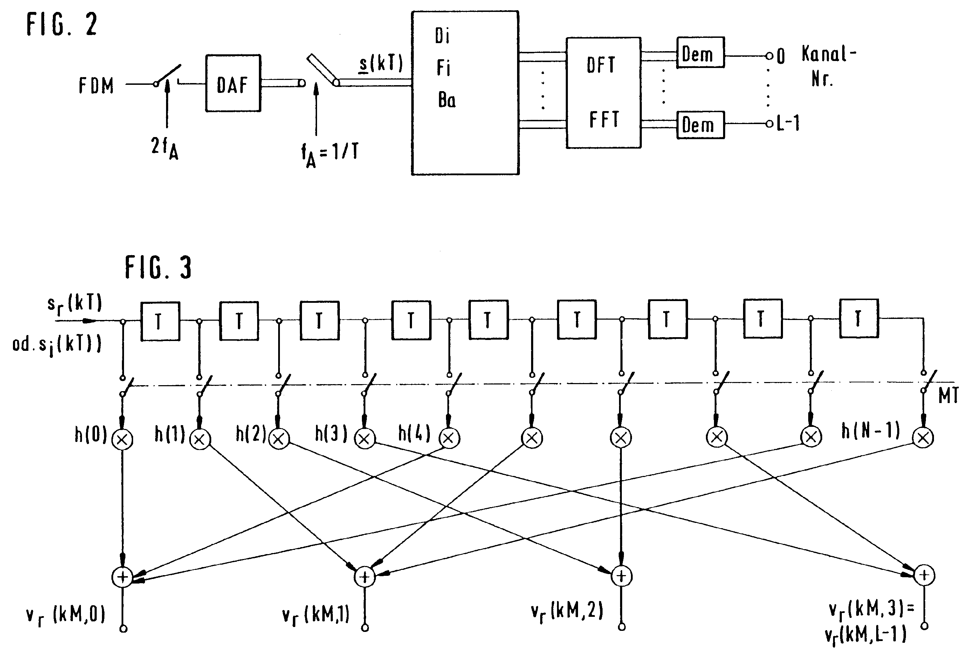

In Figur 2 ist die digitale Filterbank DiFiBa in der Mitte als Block zu erkennen. Sie wird von einem komplexen Frequenzmultilexsignal s(kT) gespeist, welches, wie das Beispiel der Figur 2 zeigt, durch Überarbeitung 2fA aus einem Frequenzmultiplexsignal FDM mit anschließender Filterung mittels eines Digital Antialiasing Filter (DAF) und anschließender Normalabtastung fA = 1/T erzeugt wird. Durch die digitale Filterbank werden L komplexe Signale erzeugt, welche anschließend mittels eines DFT- bzw. FFT Prozessors wiederum zu L komplexen Signale verarbeitet werden, welche jeweils mittels eines Demodulators DEM auf die einzelnen Kanäle demoduliert werden.

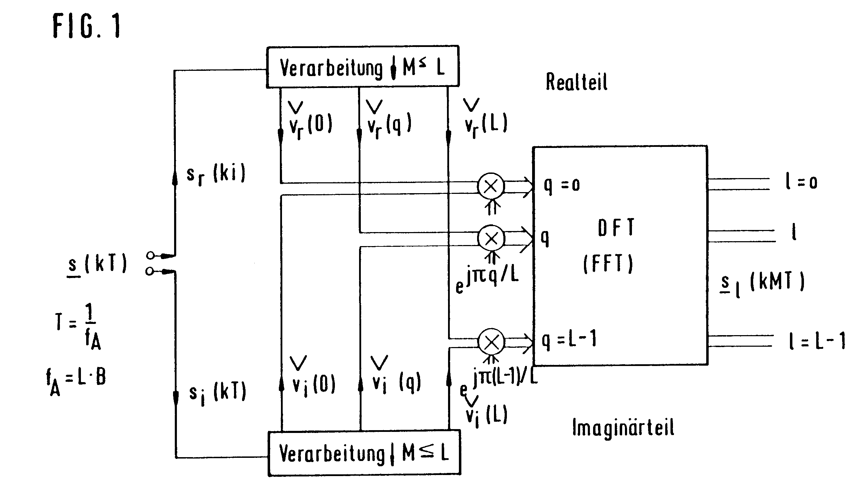

Die Figur 1 zeigt ein Blockschaltbild der digitalen Filterbank, aufgeteilt auf je einen Block für Realteil und Imaginärteil, welche Blöcke durch Verarbeitung mit einer niedrigen Abtastrate, angedeutet durch einen senkrecht nach unten zeigenden Pfeil, wobei der Reduzierungsfaktor M ≦ L beträgt, Produktsummen vr (0)... vr(L) aus dem Realteil bzw. vi(0)... vi(L) aus dem Imaginärteil erzeugen, welche als die L komplexen Eingangssignale für die anschließende diskrete oder schnelle Fourier-Transformation dienen. Das gilt für Kanalmittenfrequenzen fl = l · B mit l als laufender Kanalnummer und B der Kanalbandbreite.

Für Kanalmittenfrequenzen fl = l · B + B/2 müssen die komplexen Ausgangssignale der beiden Filterblöcke noch mit dem komplexen Faktor $e^{J\pi q/L}$ multipliziert werden, bevor sie dem Fourier-Transformator zugeführt werden, wie in Fig. 1 dargestellt.

Die Figur 3 zeigt eine Kette von N - 1 = 9 Verzögerungsgliedern der Verzögerungszeit T, in welche Kette der Realteil sr(kT) des komplexen Eingangssignals einläuft. Die N = 10 Abtastwerte der Signalfolge werden mit der Abtastrate 1/(MT) abgetastet und mit den Koeffizienten h(0),...h(N-1) der Impulsantwort des komplexen Filters multipliziert.

Anschließend werden die Produkte aus h(0), h(M)... sowie die Produkte h(1), h(1+M)... usw. zu den L = 4 Produktsummen vr(kM, 0),... vr(kM, 3) addiert. Dieselbe Anordnung wie hier für den Realteil gezeichnet, steht auch für den Imaginärteil, aus dem die Produktsummen vi(kM, 0),... vi(kM, 3) erzeugt werden.

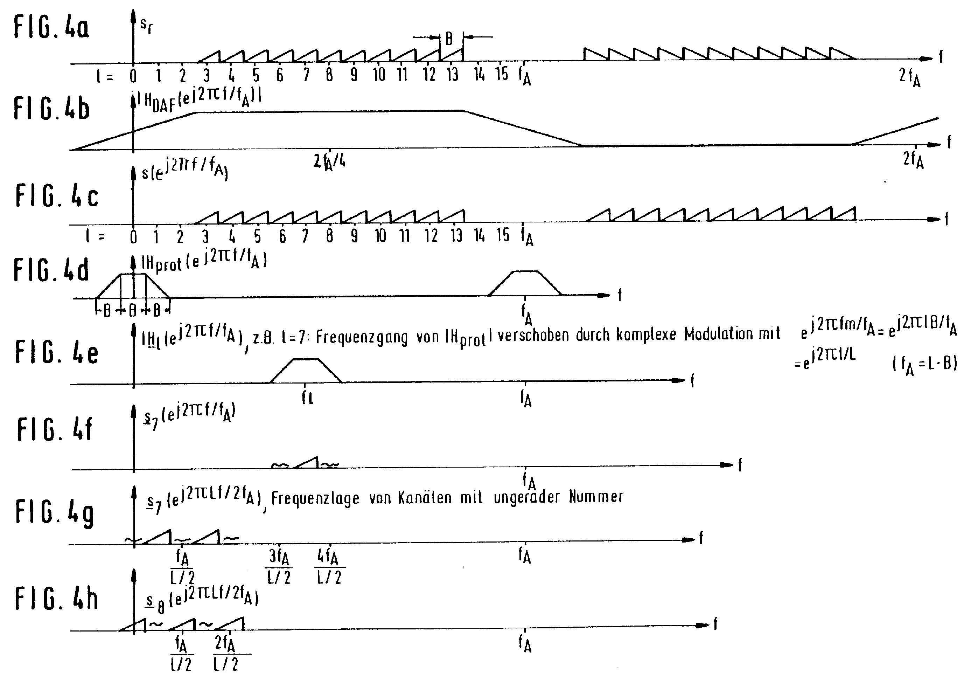

In Figur 4 sind Frequenzspektren wiedergegeben für eine digitale Filterbank mit L = 16 Kanälen, wovon aber lediglich l = 3 bis 13 benutzt werden. Das Kanalraster ist für die Mittenfrequenzen fl = l · B + B/2 ausgelegt.

EP 0 274 474 B1

In Figur 4a ist das Frequenzspektrum Sr des Frequenzmultiplexsignals als Ergebnis nach analoger Bandbegrenzung und einer Überabtastung mit der Abtastrate 2fA weidergegeben. Dabei sind die Kanäle 3 bis 13 im Bereich 0 bis fA in Normallage und im Bereich fA bis 2fA in Kehrlage zu erkennen.

Die Figur 4b gibt die Frequenzcharakteristik des DAF-Filters gemäß Figur 2 wieder. Es weist ein Übertragungsverhalten mit $|HDAF (e^{j2\pi f/fA})|$ mit komplexen Koeffizienten auf und ist, wie gezeichnet, mit einem zu fA/4 symmetrischen Durchlaßbereich versehen, wodurch es am aufwandsgünstigsten ist.

Figur 4c zeigt das Frequenzspektrum $\underline{S}(e^{j2\pi f/fA})$ des komplexen Signals $\underline{s}(kT)$ nach der periodischen Abtastung mit fA = 1/T, wobei sämtliche Kanäle 3 bis 13 in Normallage erzeugt werden. Die Figur 4d zeigt die Übertragungsfunktion $|Hprot (e^{j2\pi f/fA})|$ mit dem Durchlaßbereich von -B/2 bis +B/2 und den Filterübergangsbereichen jeweils von der Breite B. Diese Übertragungscharakteristik wiederholt sich bei Vielfachen der Abtastrate fA.

In Figur 4e ist der Frequenzgang um $l \cdot B = 7B$ durch komplexe Modulation mit $e^{j2\pi fl/fA} = e^{j2\pi lB/fA} = e^{j2\pi l/L}$ verschoben.

In Figur 4f ist das Ergebnis der Filterung mittels des vorherigen Filters wiedergegeben, es zeigt den Kanal 7 in Normallage mit aufgrund des Übergangsbereiches sich beidseitig anschließenden Resten der Nachbarkanäle.

In Figur 4g und 4h sind jeweils die Frequenzlagen von Kanälen mit ungerader $\underline{S}$ 7 $(e^{j2\pi Lf/2fA})$ und gerader Nummer $\underline{S}$ 8 $(e^{j2\pi Lf/2fA})$ wiedergegeben nach Verminderung der Abtastfrequenz um den Faktor M = L/2.

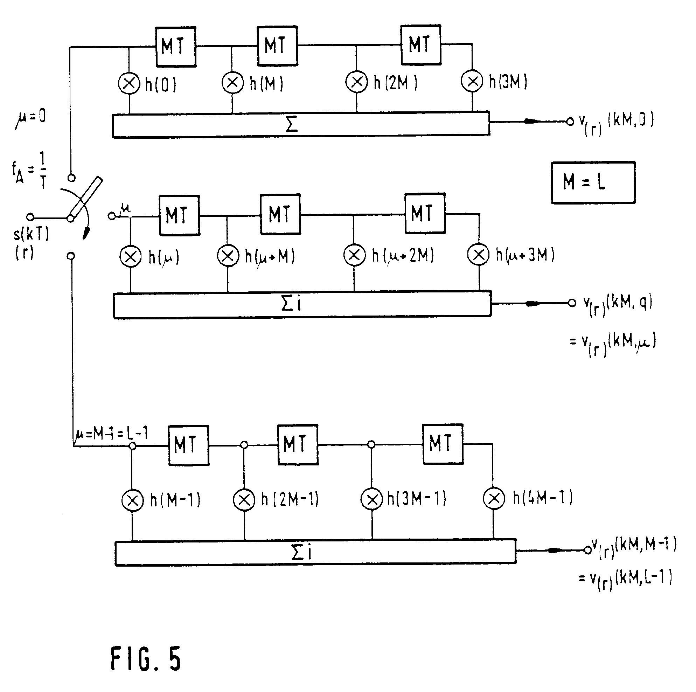

In Figur 5 ist eine Polyphasenrealisierung der digitalen Filterbank weidergegeben und zwar für den Sonderfall M = L und für Kanalmittenfrequenzen fl = l · B oder fl = lB + B/2. Gezeichnet ist stellvetretend die Verarbeitung des Realteils des komplexen Eingangssignals, welche Eingangssignalfolge sr(kT) mittels eines Demultiplexers (rotierender Schalter) auf M = L Zweige von Verzögerungsgliedern mit der Verzögerungszeit M · T mit der Abtastrate fA = 1/T verteilt wird. In jedem dieser M Stränge wird jeder M-te Wert der Teilfolgen mit den Koeffizienten h(i) mit $i = \mu + kM$ (für $\mu = 0, 1,...$ M-1 und k = 0, 1, 2,... N/M multipliziert und anschließend zu den einzelnen Produktsummen vr(kM, l) addiert.

Entscheidender Vorteil bei dieser Anordnung ist, daß mit Ausnahme des Eingangsdemultiplexer-Schalters alle Operationen einschließlich Speicherung und Verzögerung der Daten bei der verminderten Ausgangsrate fA/M erfolgen.

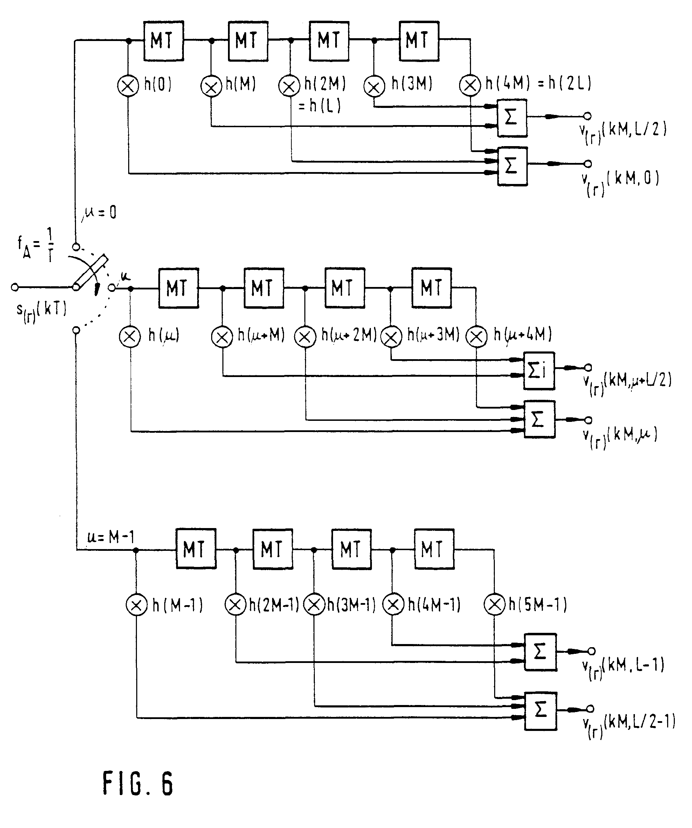

In der Figur 6 ist ein modifiziertes Polyphasennetzwerk dargestellt, wobei die erfindungsgemäße Filterbank durch M Zweigfilter mit M = L/K und für Kanalmittenfrequenzen fl = l · B oder fl = lB + B/2 realisiert ist. Stellvertretend ist wieder die Verarbeitungseinheit für den Realteil Vr(kT) des komplexen Eingangssignals dargestellt, für den Imaginärteil wird die gleiche Anordnung benötigt. Der Eingangsdemultiplexer-Schalter verteilt die Eingangssignalfolge mit der Abtastrate fA = 1/T auf die $\mu$ Zweige mit jeweils einer Kette von N/M - 1 Verzögerungsgliedern. In jeder Kette werden jeweils alle K. Werte der Teilfolge mittels k Summatoren zu den Signalen vr(kM, $\mu$) bis vr(kM, $\mu$ + L/K) für $\mu = 0, 1,...$ M-1 zusammengefaßt.

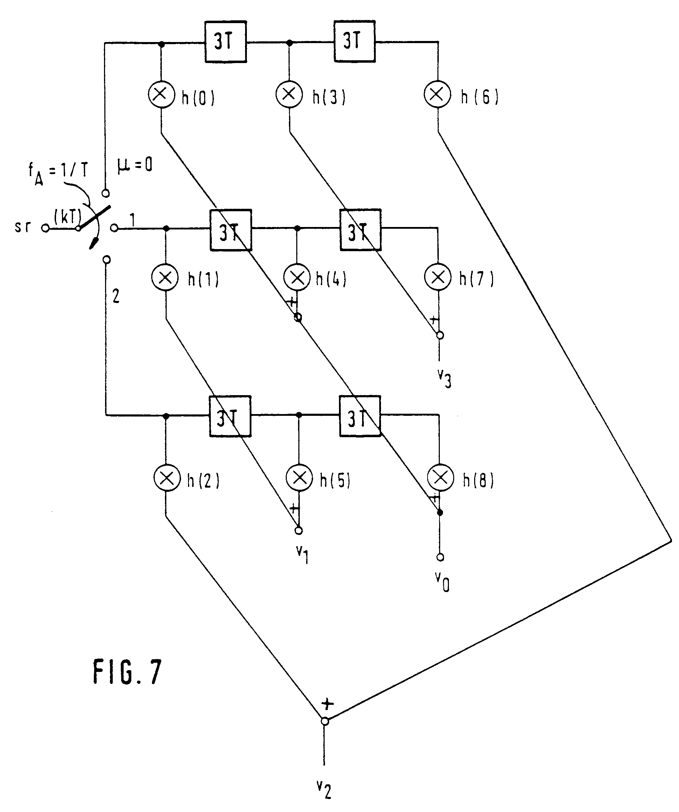

In Figur 7 ist eine modifizierte Polyphasenrealisierung des Teils der digitalen Filterbank für den Fall L = 4, M = 3, N = 9 und für Kanalmittenfrequenzen fl = l · B oder fl = l · B B/2 dargestellt. Wiedergegeben ist stellvertretend die Verarbeitungseinheit für den Realteil des komplexen Eingangssignals. Die Eingangsfolge wird mittels eines Demultiplexer-Schalters auf die Zweige $\mu$ = 0, 1, 2, die jeweils 2 Verzögerungsglieder der Verzögerungszeit 3T enthalten, verteilt. die einzelnen Werte der Teilfolgen werden mittels Koeffizienten h(i) der Impulsantwort des Filters mit i = 0, 1,... bis N - 1 = 8 multipliziert und die so entstehenden Produkte mittels L = 4 Summierer zu den Produktsummen

v0 = h0 + h4 + h8,
v1 = h1 + h5,
v2 = h2 + h6 und
v3 = h3 + h7 addiert.

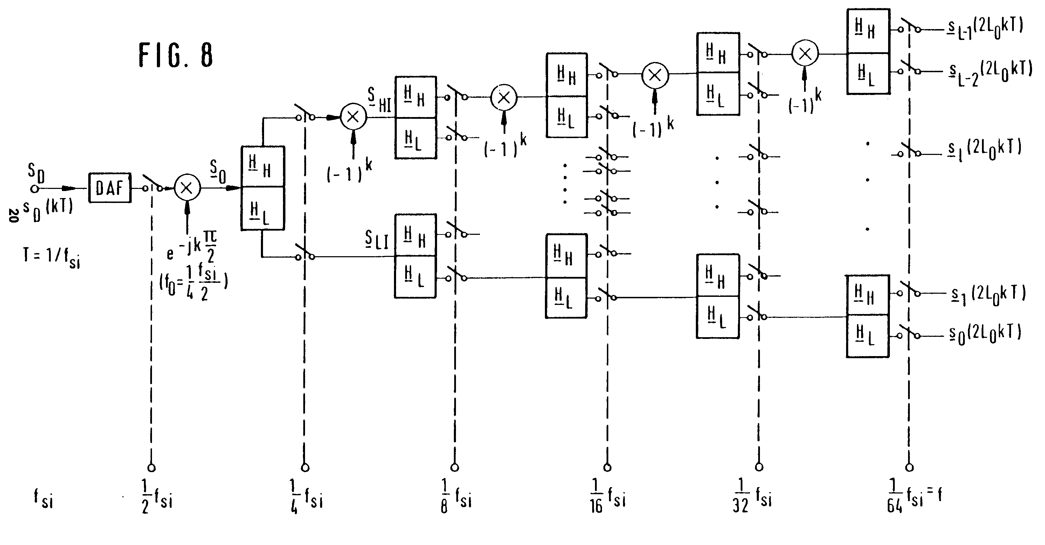

Figur 8 zeigt eine Baumstruktur-Realisierung, bei der das komplexe Eingangssignal $\underline{s}1(k)$ in Stufen jeweils mittels Filtern $\underline{H}_H$ und $\underline{H}_L$ mit komplexen Koeffizienten und jeweils unter Halbierung der Abtastrate in die komplexen Einzelsignale zerlegt wird.

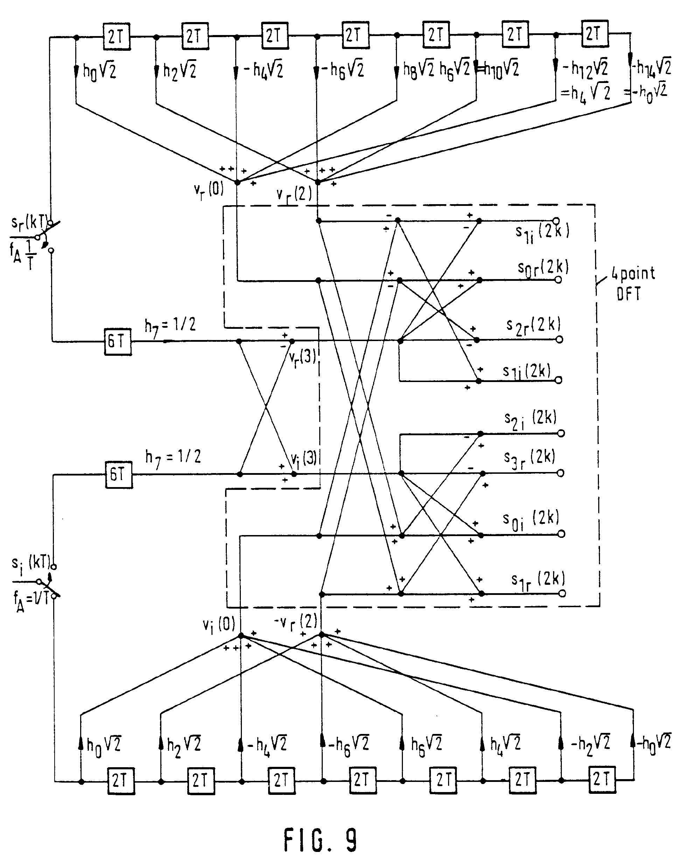

In Figur 9 ist eine besonders aufwandsgünstige Anordnung einer digitalen Filterbank dargestellt, die außerdem eine besonders aufwandsgünstige Ausführung des sich anschließenden DFT-Prozessors zur Folge hat. Die Anordnung ergibt sich für L = 4, M = 2, N = 15 (wobei N = 8u-1, $u \in \mathbb{N}$, u-beliebig sein kann) und für Kanalmittenfrequenzen fl = l · B + B/2. Dargestellt ist sowohl Real- als auch Imaginärteil, wobei beide eine identische Struktur aufweisen. Das komplexe Eingangssignal $\underline{s}(kT)$ wird mittels zweier Demultiplexer-Umschalter sowohl im Realteil als auch im Imaginärteil auf 2 Ketten von Verzögerungsgliedern im Takte der Abtastfrequenz fA = 1/T verteilt. Die 1. Kette besteht aus (N - 1)/2 = 7 Verzögerungsgliedern der Verzögerungszeit 2T, und die 2. Verzögerungslinie besteht aus einem Verzögerungsglied der Länge T(N - 3)/2 = 6T. Da die Koeffizienten h(i) für i = 1, 3, 5, 9, 11, 13 Null sind, wird lediglich der Ausgang dieses Verzögerungsgliedes 6T mit h7 = 1/2 mul-

3

tipliziert. Die Abtastwerte, welche an der 1. Verzögerungskette anstehen, werden mit h0 · √2, h2 · √2, -h4 · √2, -h6 · √2 und da die Impulsantwort in diesem Beispiel symmetrisch ist, mit h8 · √2 = h6 · √2, h10 · √2 = h4 · √2, -h12 · √2 = -h2 · √2 und -h14 · √2 = -h0 · √2 multipliziert. Anschließend werden jeweils alle M = 2. Produkte aufsummiert zu

vr(0)=√2 · (h0 · sr(k)-h4 · sr(k-4)+h6 · sr(k-8)-h2 · sr(k-12),
vi(0)=√2 · (h0 · sr(k)-h4 · sr(k-4)+h6 · sr(k-8)-h2 · sr(k-12),
-vr(2)=√2 · (h2 - h6 + h4 - h0) · si(k-i),
vi(2) =√2 · (h2 - h6 + h4 - h0) · si(k-i) sowie
vr(3) = (sr(7T) - si(7T)) · h7 und
vi(3) = (sr(7T) + si(7T)) · h7 gebildet.

Diese 3 komplexen Signale $\underline{v}$(0), $\underline{v}$(2) und $\underline{v}$(3) bilden, da, $\underline{v}$(1) identisch gleich 0 ist, die komplexen Eingangssignale für den anschließenden DFT-Prozessor, welcher lediglich einige Summationen bzw. Subtraktionen zu bilden hat:

s1r(2k) = vr(0) - vr(2) + vi(3),
S0r(2k) = vr(0) + vr(2) + vr(3),
s2r(2k) = vr(0) + vr(2) - vr(3),
s3r(2k) = vr(0) - vr(2) - vi(3),
s0i(2k) = vi(0) + vi(2) + vi(3),
s1i(2k) = vi(0) - vi(2) - vr(3),
s2i(2k) = vi(0) + vi(2) - vi(3) und
s3i(2k) = vi(0) - vi(2) + vr(3).

Für N=8μ+3, μ∈ℕ verschwindet im Gegensatz zu Fig. 9 $\underline{v}$(3)=0; dagegen ist $\underline{v}$(1)≠0. Ansonsten ergeben sich die gleichen Verhältnisse.

Es folgt nun eine mathematische Beschreibung der digitalen Filterbank für komplexe Ein- und Ausgangssignale.

Die Aufgabe besteht darin, das komplexe Eingangssignal $\underline{s}$(kT) = $\underline{s}$(k) mit dem komplexe Koeffizienten aufweisenden Filter $\underline{H}_l$($e^{j2\pi f/fA}$) aus dem Eingangsspektrum des Frequenzmultiplexsignals auszufiltern. Mit der Impulsantwort (komplex = unterstrichen)

$$\underline{h}_l(i) = h(i)\, e^{j2\pi il/L} \quad i = 0, 1,... N - 1 \quad (1)$$

des komplexen Filters, das durch Frequenzverschiebung vom reellen Prototypfilter h(i) $\hat{=}$ $H_{prot}$ ($e^{j2\pi f/fA}$) abgeleitet ist, ergibt sich das (komplexe) Ausgangssignal als Faltungsprodukt

$$\underline{s}_l(k) = \sum_{i=-\infty}^{\infty} \underline{s}(k - i)\, \underline{h}_l(i)$$

$$= \sum_{i=-\infty}^{\infty} \underline{s}(k - i)\, h(i)\, e^{j2\pi il/L} \quad (2)$$

Das gewünschte Signal, das auf die um den Faktor M ≦ L verminderte Abtasfrequenz fA/M bezogen ist, ergibt sich dann zu

$$\underline{s}_l(kM) = \sum_{i=-\infty}^{\infty} \underline{s}(kM-i)\,h(i)\, e^{j2\pi il/L} \quad (3)$$

Es werden nun Blöcke der Länge L zur geeigneten Verarbeitung gebildet mit

$$i = Lp + q, \text{ wobei } p = -\infty...\infty,\ q = 0, 1,... L - 1. \quad (4)$$

Eingesetzt in (3) ergibt sich

$$\underline{s}_l(kM) = \sum_{q=0}^{L-1} \sum_{p=-\infty}^{\infty} \underline{s}(kM-Lp-q)\, h(Lp+q)\, e^{j2\pi(Lp+q)l/L} \quad (5)$$

Dabei läßt sich der Exponentialterm vereinfachen (p,l,L∈ N) zu

$$e^{j2\pi(Lp + q)l/L} = e^{j2\pi pl}\, e^{j2\pi ql/L} = e^{j2\pi ql/L} \quad (6)$$

EP 0 274 474 B1

Damit ergibt sich mit einer Abkürzung für die für alle Kanäle l gleichen komplexen Größen $\underline{v}(kM,q)$:

$$\underline{v}(kM,q) = \sum_{p=-\infty}^{\infty} \underline{s}(kM-pL-q)\, h(pL+q) \qquad (7a)$$

$$\underline{s}_1(kM) = \sum_{q=0}^{L-1} \underline{v}(kM,q)\, e^{j2\pi ql/L} = DFT\left\{\underline{v}(kM,q)\right\} \qquad (7b)$$

Dies gilt für Kanalmittenfrequenzen fl = l · B.

Die Realisierung der Beziehungen (7) ist in Fig. 1 im Zusammenhang mit Fig. 3 dargestellt. Zunächst ist eine Verarbeitung zur Bildung der komlexen Größen $\underline{v}(kM,q)$ mit der um den Faktor M verminderten Abtastfrequenz erforderlich (7a). S. Fig. 3; dabei sind die Teile zur Berechnung des Realteils bzw. des Imaginärteils identisch.

Die komplexen Größen $\underline{v}(kM,q)$, l=0... L-1 sind als Block der DFT der Länge L zu unterwerfen. Dabei wird die Effizienz des DFT- (bzw. eines beliebigen FFT-) Algorithmus optimal ausgenutzt, da sowohl als Eingangsals auch als Ausgangsgrößen komplexe Signale verlangt sind.

Es ist auch möglich, daß das Kanalraster um eine halbe Kanalbandbreite oder auch beliebig um $\frac{n}{m}$ verschoben ist (n, m $\in$ $\mathbb{N}$ ; n < m) ist gegenüber Fig. 4. Dann gilt anstelle von (1)

$$\underline{h}_1(i) = h(i)\, e^{j2\pi i\frac{(1+n/m)}{L}} \qquad (8).$$

Dann bekommt (5) die Form

$$\underline{s}_1(kM) = \sum_{q=0}^{L-1} \sum_{p=-\infty}^{\infty} \underline{s}(kM-pL-q)\, h(pL+q)\, e^{j2\pi\frac{(Lp+q)(1+n/m)}{L}} \qquad (9)$$

und der Exponentialausdruck (6) n, m $\in$ $\mathbb{N}$ ,n < m,

$$e^{j2\pi\frac{(Lp+q)(1+n/m)}{L}} = e^{j2\pi\frac{ql}{L}}\, e^{j2\pi p\frac{n}{m}}\, e^{j2\pi\frac{qn}{Lm}} \qquad (10)$$

Damit wird aus (7) mit

$$\underline{\tilde{v}}(kM,q) = \sum_{p=-\infty}^{\infty} \underline{s}(kM-pL-q)\, h(pL+q)\, e^{j2\pi p\frac{n}{m}}\, e^{j2\pi\frac{qn}{Lm}} \qquad (11a)$$

$$= \sum_{p=-\infty}^{\infty} \underline{s}(kM-pL-q)\, \underline{h}(pL+q)$$

$$\underline{s}_1(kM) = \sum_{q=0}^{L-1} \underline{\tilde{v}}(kM,q)\, e^{j2\pi\frac{ql}{L}} = DFT\left\{\underline{\tilde{v}}(kM,q)\right\} \qquad (11b)$$

Dies gilt also allgemein für die Kanalmittenfrequenzen fl = l · B + B · n/m.

Anstelle der ursprünglich reellen Koeffizienten h(pL+q) treten die komplexen Koeefizienten

5

$$\underline{h}(pL+q) = h(pL+q)\ e^{j2\pi p\frac{n}{m}}\ e^{j2\pi\frac{qn}{Lm}} \qquad\qquad (11c),$$

was zur Berechnung der Größen $\widetilde{\underline{v}}$ (kM,q) einer Verdoppelung der ursprünglichen Anzahl der Multiplikationen und Additionen entspricht.

Für m = 2 und m = 4 besteht auch die Möglichkeit zur Berechnung von $\widetilde{\underline{v}}$( (kM,q) über

$$\overset{\vee}{\underline{v}}(kM,q) = \sum_{p=-\infty}^{\sim} \underline{s}(kM-pL-q)\ h(pL+q)\ e^{j2\pi p\frac{n}{m}} \qquad\qquad (12a),$$

wobei für m = 2

$$e^{j2\pi p\frac{n}{2}} = (-1)^{np} \qquad\qquad (12b)$$

und für m = 4

$$e^{j2\pi p\frac{n}{4}} = j^{np} \qquad\qquad (12c)$$

gilt. Damit ist der Aufwand zur Berechnung von $\overset{\vee}{\underline{v}}$( (kM,q) Gl. (12a) und von $\underline{v}$(kM,q) Gl. (7a) identisch. Damit ergibt sich schließlich

$$\widetilde{\underline{v}}(kM,q) = \overset{\vee}{\underline{v}}(kM,q)\ e^{j2\pi\frac{qn}{Lm}} \qquad\qquad (12d),$$

was für jedes q = 0, 1,... L - 1 im allgemeinen 4 Multiplikationen und 2 Additionen zusätzlich erforderlich macht falls n≠0 ist. Verglichen mit dem Ansatz Gl. (11) ist der Aufwand von Ansatz Gl. (12) stets dann geringer, wenn

$$4L < 2N \qquad (13)$$

gilt, was häufig der Fall ist.

Eine andere Möglichkeit für m = 2 und m = 4 ist, die Faktoren

$$e^{j2\pi\frac{qn}{Lm}}$$

(12d) mit der DFT zu einer ungeraden (ODFT) zusammenzufassen, was zu einer weiteren Aufwandsverminderung führt.

Für beliebige Netzwerke zur digitalen Signalverarbeitung ist bekannt, daß sie durch Transposition in Netzwerke mit der dualen Funktion überführbar sind. So kann eine digitale Filterbank zur frequenzmäßigen Trennung von Frequenzmultiplex-Signalen mit der Methode der Transposition in eine Filterbank zur frequenzmäßigen Zusammenführung von Einzelsignalen in ein Frequenzmultiplex-Signal umgewandelt werden. Das bedeutet für die bisher beschriebenen Strukturen, daß alle Signalflußrichtungen umgekehrt werden (Vertauschung von Ein- und Ausgang, Addierer wird Verzweiger, Verzweiger wird Addierer, DFT wird inverse DFT). Die Methode der Transposition digitaler Netzwerke ist beschrieben in dem Aufsatz "On the transposition of linear time-varying discrete-time networks and its application to multirate digital systems", Philips J. Res. Bd. 33, 1978, S. 78 bis 102.

**Patentansprüche**

1. Digitale Filterbank zur frequenzmäßigen Trennung eines mit der Abtastfrequenz fA abgetasteten aus höchstens L Einzelsignalen der Bandbreite B zusammengesetzten Frequenzmultiplexsignals, wobei die Produktsummen

$$v(k,q) = \sum_{p=-\infty}^{+\infty} s(k-i) \cdot h(i) \cdot e^{j2\pi in/(mL)}$$

mit n = 0 oder n = 1 und m = 2,

$i = p \cdot L + q$,

$q = 0, 1, 2,... L-1$,

$i, p, q = \{0, 1, 2, 3,...\}$,

aus dem mit der Abtastfrequenz fA = 1/T abgetasteten Eingangssignal s(k), der endlich langen Impulsantwort h(i) für i = 0, 1, 2,...,N-1 des Prototyp-Filters und einem komplexen Drehfaktor einer Diskreten Fourier-Transformation (DFT) zur Bildung von L komplexen Ausgangssignalen

$$\underline{s}l(kM) = \sum_{q=0}^{L-1} \underline{v}(kM,q) \cdot e^{j2\pi ql/L} = DFT\left\{\underline{v}(kM,q)\right\}$$

unterworfen sind, wobei durch Verminderung der Abtastrate um den Faktor M ≦ L nur jeder M-te Wert der Produktsummen in der DFT bearbeitet wird, für Kanalmittenfrequenzen fl = I · B + B · n/m, wobei I die laufende Nimmer des Kanals mit 0, 1, 2... L-1 ist, <u>dadurch gekennzeichnet</u>, daß das eingangsseitige Frequenzmultiplex-Signal eine komplexe Größe <u>s</u>(kT) = sr-kT) + j · si(kT) ist mit dem Realteil Re = sr(kT) und dem Imaginärteil Im = si(kT), wobei j = √-1 und der Zeitfaktor k = ... -1, 0, +1, ... sind,

daß Realteil und Imaginärteil des Einganssignals jeweils in gleiche Anordnungen gespeist werden,

daß diese Anordnungen jeweils aus einem Eingangsdemultiplexer (rotierender Schalter) mit M Stellungen besteht, wobei in jeder Stellung eine Kette von höchstens <N/M> Verzögerungsgliedern der Verzögerungszeit M · T speisbar ist, wobei <N/M> die nächstkleinere ganze Zahl angibt, wenn N/M keine ganze Zahl ist,

daß der Eingangsdemultiplexer die mit der Abtastrate fA gelieferten Werte des Eingangssignals zyklisch jeweils auf aufeinanderfolgende Ketten μ = 0, 1, ... M-1, 0, 1,... verteilt, so daß die Eingangssignalfolge in M Teilfolgen der auf fA/M verminderten Abtastrate aufgeteilt wird,

daß die verschiedenen Abtastwerte der M Teilfolgen mit Koeffizienten h(√) √ = 0, 1,... N-1 multipliziert werden,

so daß für die μ-te Teilfolge folgende Produkte entstehen:

$$P(\mu) = s\mu(kM - \sqrt{M}) \cdot h(\mu + \sqrt{M}), \sqrt{} = 0, 1, 2,...,$$

daß jeweils die Produkte P(μ, M) zu komplexen Zwischensignalen <u>v</u>(kM,q) derart zusammengefaßt werden, daß L Summensignale entstehen, die die einzelnen Summanden P(μ) enthalten für μ = pM + p · λ + q - αM, einer Integer Division (ganzzahliger Anteil des Divisionsergebnisses)

α = (pM + p · λ + q)/M (Figur 7) und λ = L-M und

daß die komplexen Zwischensignale <u>v</u>(kM,q) vor der Diskreten Fourier-Transformation jeweils mit komplexen Koeffizienten e^{jπnq/L} (= 1 für n = 0) multipliziert werden.

2. Digitale Filterbank nach Anspruch 1, für M = L/R, mit R ≦ L, R = 1, 2, 3,..., <u>dadurch gekennzeichnet</u>, daß aus den bei jeder Teilfolge anstehenden Produkten jeweils R Summationen durchgeführt werden, wobei der 1. Summierer das 1., (R + 1)., (2R +1)...Produkt zu v(kM,μ) zusammenfaßt, wobei der 2. Summierer das 2., (R + 2)., (2R + 2). Produkt zusammenfaßt zu v(kM, μ + L/R) und wobei der R-te Summierer das R-te Produkt, das 2R-te Produkt, das 3R-te Produkt usw. zusammenfaßt zu v(kM, (R-1) · L/R),.

3. Digitale Filterbank nach Anspruch 1, für M = L, <u>dadurch gekennzeichnet</u>, daß für jede der M Teilfolgen alle Produkte P(μ) = P(q) jeweils aufsummiert werden zu den L Produktsummen v(kM, q) für Real- und Imaginärteil von <u>v</u>(kM, q).

4. Digitale Filterbank nach einem der vorhergehenden Ansprüche, <u>dadurch gekennzeichnet</u>, daß mehrere digitale Filterbänke in einer Baumstruktur stufenweise sich verzweigend hintereinander angeordnet sind, wobei ausgehend von der 1. Stufe (Baumspitze) in der √-ten Stufe (√ = 1, 2,...) eine Separierung in L√ Einzelsignale erfolgt, wobei die Abtastrate jeweils um den Faktor M√ ≦ L√ in der √-ten Stufe vermindert wird.

5. Digitale Filterbank nach einem der vorhergehenden Ansprüche, dadurch gekennzeichnet, daß das komplexe Eingangssignal der digitalen Filterbank mit Hilfe eines Filters mit komplexen Koeffizienten von einem reellen mit der doppelten Abtastfrequenz ($2f_A$) abgetasteten Frequenzmultiplexsignal abgeleitet ist.

6. Digitale Filterbank nach Anspruch 1 oder 2 mit L = 4, M = 2, m = 2 und n = 1, N = 8$\mu$-1 ($\mu$ = 1, 2, 3,...) für Kanalfrequenzen fl = I · B + B/2, dadurch gekennzeichnet,

daß Realteil und Imaginärteil des komplexen Eingangssignales $\underline{s}$(kT) jeweils mittels eines mit der Abtastfrequenz fA = 1/T schaltenden Umschalters zu einem ersten Zeitpunkt auf eine 1. Kette von (N-1)/2 Verzögerungsgliedern mit der Verzögerungszeit 2T und zu einem 2. Zeitpunkt auf 1 Verzögerungsglied der Länge T(N-3)/2 gespeist wird,

daß von der 1. Kette mit Verzögerungsgliedern 2T jeweils die Eingangsabtastwerte des 1., 3., 5., 7. usw. Verzögerungsgliedes mit den mit $\sqrt{2}$ skalierten Koeffizienten h(4i), i = 0, 1, 2,... multipliziert und im Realteil- bzw. Imaginärteilzweig zu den Produktsummen vr(o) bzw. vi(o) zusammengefaßt werden und jeweils die Eingangsabtastwerte des 2., 4., 6., 8. usw. Verzögerungsgliedes mit den mit $\sqrt{2}$ skalierten Koeffizienten h(4i + 2), i = 0, 1, 2,... multipliziert und im Realteil- bzw. Imaginärteilzweig zu den Produktsummen vi(2) bzw. -vr(2) zusammengefaßt werden, indem jeweils das 1. und 2., das 5. und 6. usw. Produkt positiv und jeweils das 3. und 4., das 7. und 8. usw. Produkt negativ bewertet wird,

daß die 2. Teilfolge jeweils am Ausgang der T(N-3)/2 Verzögerungsglieder mit h($\frac{N-1}{2}$) = 1/2 multipliziert werden,

daß anschließend die Summe gebildet wird aus beiden Produkten zu vi(3) und die Differenz des Produktes aus dem Realteil minus dem Produkt aus dem Imaginärteil zu vr(3), wobei vr(0) mit vi(0), -vr(2) mit vi(2) und vr(3) mit vi(3) dem DFT-Prozessor als komplexe Signale zugeführt werden,

daß der DFT-Prozessor aus den 3 komplexen Eingangssignallen 4 komplexe Ausgangssignale $\underline{s}$0(2k)... $\underline{s}$3(2k) derart bildet, daß

s0r(2k) = vr(0) + vr(r) + vr(3)
s0i(2k) = vi(0) + vi(2) + vi(3)
s1r(2k) = vr(0) - vr(2) + vi(3)
s1i(2k) = vi(0) - vi(2) - vr(3)
s2r(2k) = vr(0) + vr(2) - vr(3)
s2i(2k) = vi(0) + vi(2) - vi(3)
s3r(2k) = vr(0) - vr(2) - vi(3) und
s3i(2k) = vi(0) - vi(2) + vr(3) ist.

7. Digitale Filterbank nach Anspruch 1 oder 2, mit L= 4, M= 2, m = 2 und n = 1, N = 8$\mu$+3($\mu$=1, 2, 3...) für Kanalfrequenzen fl = I · B + B/2, dadurch gekennzeichnet,

daß Realteil und Imaginärteil des komplexen Eingangssignales $\underline{s}$(kT) jeweils mittels eines mit der Abtastfrequenz fA = 1/T schaltenden Umschalters zu einem ersten Zeitpunkt auf eine 1. Kette von (N-1)/2 Verzögerungsgliedern mit der Verzögerungszeit 2T und zu einem 2. Zeitpunkt auf 1 Verzögerungsglied der Länge T(N-3)/2 gespeist wird,

daß von der 1. Kette mit Verzögerungsgliedern 2T jeweils die Eingangsabtastwerte des 1., 3., 5., 7. usw. Verzögerungsgliedes mit den mit $\sqrt{2}$ skalierten Koeffizienten h(4i), i = 0, 1, 2,... multipliziert und im Realteil bzw. Imaginärteilzweig zu den Produktsummen vr(0) bzw. vi(0) zusammengefaßt werden und jeweils die Eingangsabtastwerte des 2., 4., 6., 8. usw. Verzögerungsgliedes mit den mit $\sqrt{2}$ skalierten Koeffizienten h(4i + 2), i = 0, 1, 2,... multipliziert und im Realteil- bzw. Imaginärteilzweig zu den Produktsummen vi(2) bzw. -vr(2) zusammengefaßt werden, indem jeweils das 1. und 2., das 5. und 6. usw. Produkt positiv und jeweils das 3. und 4., das 7. und 8. usw. Produkt negativ bewertet wird,

daß die 2. Teilfolge jeweils am Ausgang der T(N-3)/2 Verzögerungsglieder mit h($\frac{N-1}{2}$) = 1/2 multipliziert werden,

daß anschließend die Summe gebildet wird aus beiden Produkten zu -vi(1) und die Differenz des Produktes aus dem Realteil minus dem Produkt aus dem Imaginärteil zu -vr(1), wobei vr(0) mit vi(0), -vr(1) mit -vi(1) und -vr(2) mit vi(2) dem DFT-Prozessor als komplexe Signale zugeführt werden,

daß der DFT-Prozessor aus den 3 komplexen Eingangssignalen 4 komplexe Ausgangssignale $\underline{s}$0(2k)... $\underline{s}$3(2k) derart bildet, daß

s0r(2k) = vr(0) + vr(1) + vr(2)
s0i(2k) = vi(0) + vi(1) + vi(2)
s1r(2k) = vr(0) - vi(1) - vr(2)
s1i(2k) = vi(0) + vr(1) - vi(2)
s2r(2k) = vr(0) - vr(1) + vr(2)

s2i(2k) = vi(0) - vi(1) + vi(2)
s3r(2k) = vr(0) + vi(1) - vr(2) und
s3i(2k) = vi(0) - vr(1) - vi(2).

8. Digitale Filterbank zur frequenzmäßigen Zusammenführung (Frequenzmultiplexbildung) von höchstens L mit der Abtastfrequenz fA/M (M ≦ L) abgetasteten Einzelsignalen der Bandbreite B, dadurch gekennzeichnet, daß eine digitale Filterbank nach einem der vorhergehenden Ansprüche verwendert wird, wobei alle Signalflußrichtungen umgekehrt sind, Ein- und Ausgänge der Filterbank vertauscht sind, Summierer durch Verzweigungspunkte und Verzweigungspunkte durch Summierer ersetzt sind, die Diskrete Fourier-Transformation (DFT) durch die inverse Diskrete Fourier-Transformation ersetzt ist, wobei die Verminderung der Abtastfrequenz fA um den Faktor M (↓M) durch die Erhöhung der Abtastfrequenz fA/M um den Faktor M (↑M) ersetzt ist und wobei alle Schalterfunktionen zum Demultiplexen durch Solche zum Multiplexen ersetzt sind (Transposition digitaler Netzwerke).

## Claims

1. A digital filter bank for the frequency separation of a frequency multiplex signal sampled at a sampling rate fA and composed of at most L individual signals of a band-width B, wherein the product sums

$$v(k,q) = \sum_{p=-\infty}^{+\infty} s(k-i) \cdot h(i) \cdot e^{j2\pi in/(mL)}$$

where

n = 0 or n = 1 and m = 2,
i = p · L + q,
q = 0, 1, 2, ... L - 1,
i, p, q = (0, 1, 2, 3, ...)

from the input signal s(k) sampled at the sampling rate fA = 1/T, the pulse response h(i) of a finite length for i = 0, 1, 2, ..., N-1 of the prototype filter and a complex rotation factor are subjected to a discrete Fourier transformation (DFT) so as to form L complex output signals

$$\underline{s}l(kM) = \sum_{q=0}^{L-1} \underline{v}(kM,q) \cdot e^{j2\pi ql/L} = DFT\ [\underline{v}(kM,q)]$$

with the sampling rate being reduced by the factor M ≦ L so that only every M$^{th}$ value of the produkt sums is processed in the DFT, for channel center frequencies fl = l · B + B · n/m, with l being the consecutive number of the channel, such as 0, 1, 2,..., L-1, characterised in that the frequency multiplex signal at the input is a complex value $\underline{s}(kT) = sr(kT) + j \cdot si(kT)$ composed of the real portion Re = sr(kT) and the imaginary portion Im = si(kT), where j = √-1 and the time factor k = ..., -1, 0, +1, ...;

the real portion and the imaginary portion of the input signal are each fed into identical arrangements;

these arrangements are each composed of an input demultiplexer (rotating switch) having M positions, with a chain of at most <N/M> delay members having a delay of M · T being feedable in each position, where <N/M> is the next lower integer, if N/M is not an integer;

the input demultiplexer cyclically distributes the input signal values furnished at the sampling rate fA to successive chains μ = 0, 1, ..., M-1, 0, 1, ..., so that the input signal sequence is divided into M partial sequences at a sampling rate which has been reduced to fA/M;

the various sampled values of the M partial sequences are multiplied by coefficients h(√) where √ = 0, 1, ..., N-1, so that for the μ$^{th}$ partial sequence the following products result:
P(μ) = sμ(kM - √M) · h(μ + √M), where √ = 0, 1, 2, ...;

the products P(μ, M) are combined into complex intermediate signals v(kM,q) in such a manner that L sum signals result which contain the individual summands P(μ) for μ = pM + p · λ + q - αM, an integer division (whole number component of the result of the division) α= (pM + p · λ + q)/M (Figure 7) and λ = L - M; and before the discrete Fourier transformation, the complex intermediate signals v(kM,q) are each multiplied by

complex coefficients $e^{j\pi nq/L}$ (= 1 for n = 0).

2. A digital filter bank according to claim 1, for M = L/R, with R $\leqq$ L, R = 1, 2, 3, ..., <u>characterised in that</u> R summations are made from the products obtained in each partial sequence, with the first summing member combining the first, $(R + 1)^{th}$, $(2R + 1)^{th}$ product to form v(kM,$\mu$), the second summing member combining the second, $(R + 2)^{th}$, $(2R + 2)^{th}$ product to form v(kM, $\mu$ + L/R) and the $R^{th}$ summing member combining the $R^{th}$ product, the $2R^{th}$ product, the $3R^{th}$ product, etc. to form v(kM, (R-1) · L/R).

3. A digital filter bank according to claim 1, for M = L, <u>characterised in that</u> for each of the M partial sequences, all products P($\mu$) = P(q) are summed up to form the L product sums v(kM,q) for the real portion and for the imaginary portion of <u>v</u>(kM,q).

4. A digital filter bank according to one of the preceding claims, <u>characterised in that</u> a plurality of digital filter banks are arranged one behind the other to branch out in successive steps into a tree structure and, starting with the first stage (top of the tree), separation into L√ individual signals occurs in the √th stage (√ = 1, 2, ...), with the sampling rate being reduced in the √th stage each time by the factor M√ < L√.

5. A digital filter bank according to one of the preceding claims, <u>characterised in that</u> the complex input signal of the digital filter bank is derived, with the aid of a filter having complex coefficients, from a real frequency multiplex signal sampled at the double sampling rate ($2f_A$).

6. A digital filter bank according to claim 1 or 2 where L = 4, M = 2, m = 2 and n = 1, N = $\varepsilon\mu$-1 ($\mu$ = 1, 2, 3, ...) for channel frequencies fl = l · B + B/2, <u>characterised in that</u>

the real portion and the imaginary portion of the complex input signal <u>s</u>(kT) are each fed, at a first point in time, by means of a switch switching at the sampling rate fA = 1/T, to a first chain of (N-1)/2 delay members having a delay of 2T and, at a second point in time, to one delay member having a length of T(N-3)/2;

the input sample values obtained from the first chain of delay members 2T at the first, third, fifth, seventh, etc. delay member are multiplied by the √2 scaled coefficients h(4i) where i = 0, 1, 2, ..., and are combined in the real portion branch and in the imaginary portion branch to form the product sums vr(0) and vi(0), respectively, and the respective input sample values of the second, fourth, sixth, eighth, etc. delay member are multiplied by the √2 scaled coefficients h(4i + 2), where i = 0, 1, 2, ..., and are combined in the real portion branch and in the imaginary portion branch to form the product sums vi(2) and -vr(2), respectively, in that the first and second, the fifth and sixth, etc., products are evaluated to be positive and the third and fourth, the seventh and eighth, etc. products are evaluated to be negative;

the second partial sequence at the outputs of the T(N-3)/2 delay members are multiplied by h[(N-1)/2] = 1/2;

thereafter, the sum is formed of the two products to provide vi(3) and the difference of the product from the real portion minus the product from the imaginary portion is formed to provide vr(3), where the DFT processor is fed with vr(0) together with vi(0), -vr(2) together with vi(2), and vr(3) together with vi(3) as the complex signals;

the DFT processor forms four complex output signals <u>s0</u>(2k) ... <u>s3</u>(2k) from the three complex input signals in such a manner that

s0r(2k) = vr(0) + vr(r) + vr(3),
s0i(2k) = vi(0) + vi(2) + vi(3),
s1r(2k) = vr(0) - vr(2) + vi(3),
s1i-(2k)= vi(0) - vi(2) - vr(3),
s2r(2k) = vr(0) + vr(2) - vr(3),
s2i(2k) = vi(0) + vi(2) - vi(3),
s3r(2k) = vr(0) - vr(2) - vi(3), and
s3i(2k) = vi(0) - vi(2) + vr(3).

7. A digital filter bank according to claim 1 or 2, where L = 4, M = 2, m = 2 and n = 1, N = 8u + 3 (u = 1, 2, 3, ...) for channel frequencies fl = l · B + B/2, <u>characterised in that</u>

the real portion and the imaginary portion of the complex input signal <u>s</u>(kT) are each fed, at a first point in time, by means of a switch switching at the sampling rate fA = 1/T, to a first chain of (N-1)/2 delay members having a delay of 2T and, at a second point in time, to one delay member having a length of T(N-3)/2;

the input sample values obtained from the first chain of delay members 2T at the first, third, fifth, seventh, etc. delay member are multiplied by the √2 scaled coefficients h(4i) where i = 0, 1, 2, ..., and are combined in the real portion branch and in the imaginary portion branch to form the product sums vr(0) and vi(0), respectively, and the respective input sample values of the second, fourth, sixth, eighth, etc. delay member are multiplied by the √2 scaled coefficients h(4i + 2), where i = 0, 1, 2, ..., and are combined in the real portion branch and in the imaginary portion branch, respectively, to form the product sums vi(2) and -vr(2), respectively, in that the first and second, the fifth and sixth, etc., products are evaluated to be positive and the third and fourth, the seventh and eighth, etc. products are evaluated to be negative;

the second partial sequence at the outputs of the T(N-3)/2 delay members are multiplied by h[(N-1)/2] = 1/2;

thereafter, the sum is formed of the two products to provide -vi(1) and the difference of the product from the real portion minus the product from the imaginary portion is formed to provide -vr(1), with the DFT processor being fed with vr(0) together with vi(0), -vr(1) together with -vi(1), and -vr(2) together with vi(2) as the complex signals;

the DFT processor forms four complex output signals s0(2k) ... s3(2k) from the three complex input signals in such a manner that

s0r(2k) = vr(0) + vr(1) + vr(2),
s0i(2k) = vi(0) + vi(1) + vi(2),
s1r(2k) = vr(0) - vi(1) - vr(2),
s1i(2k) = vi(0) + vr(1) - vi(2),
s2r(2k) = vr(0) - vr(1) + vr(2),
s2i(2k) = vi(0) - vi(1) + vi(2),
s3r(2k) = vr(0) + vi(1) - vr(2), and
s3i(2k) = vi(0) - vr(1) - vi(2).

8. A digital filter bank for the frequency combination (frequency multiplex formation) of at most L individual signals sampled at the sampling rate fA/M (M ≦ L) of a bandwith B, characterised in that

a digital filter bank according to one of the preceding claims is employed in which all signal flow directions are reversed, inputs and outputs of the filter bank are exchanged, summing members are replaced by branching points and branching points by summing members, the discrete Fourier transformation (DFT) is replaced by an inverse discrete Fourier transformation, the reduction of the sampling rate fA by the factor M(↓M) is replaced by an increase in the sampling rate fA/M by the factor M(↑M) and all switch functions for demultiplexing are replaced by switch functions for multiplexing (transposition of digital networks).

**Revendications**

1. Banc de filtrage numérique pour la séparation dans le domaine des fréquences d'un signal multiplexé en fréquence, échantillonné à la fréquence d'échantillonnage fA et composé de tout au plus L signaux élémentaires de largeur de bande B, dans lequel les sommes des produits

$$v(k,q) = \sum_{p=-\infty}^{+\infty} s(k-i) \cdot h(i) \cdot e^{j2\pi i n/(mL)}$$

où

n = 0 ou n = 1 et m = 2,
i = p · L + q,
q = 0, 1, 2, ... L-1,
i, p, q, = {0, 1, 2, 3,}... ,

obtenus à partir du signal d'entrée s(k) échantilloné à la fréquence d'échantillonage fA = 1/T, sont soumises à la réponse impulsionnelle h(i) de longueur finie, pour i = 0, 1, 2, ..., N-1 du filtre prototype et à un facteur de rotation complexe d'une transformée de Fourier discrète (TFD) pour la formation de L signaux de sortie complexes

$$\underline{s}l(kM) = \sum_{q=0}^{L-1} \underline{v}(kM,q) \cdot e^{j2\pi q l/L} = TFD\ \underline{v}(kM,q),$$

dans lequel, par la diminution de la fréquence d'échantillonnage du facteur M ≦ L, seulement chaque M-ième valeur des sommes des produits est traitée dans la TFD, pour des fréquences centrales de canaux fl = l B + B · n/m, l étant le numéro d'ordre du canal, avec 0, 1, 2 ... L-1, caractérisé en ce que le signal multiplexé en fréquence, côté entrée, est une grandeur complexe s(kT) = sr(kT) + j · si(kT) comportant la partie réelle Re = sr(kT) et la partie imaginaire Im = si(kT), où j = √-1 et le facteur temps k = ... -1, 0, +1, ...,

que la partie réelle et la partie imaginaire du signal d'entrée sont injectées séparément dans des dispositifs identiques,

que chacun de ces dispositifs est formé d'un démultiplexeur d'entrée (commutateur tournant) avec M positions, avec la possibilité d'alimenter, à chaque position, une chaîne de tout au plus <N/M> éléments de retard, produisant le temps de retard M · T, où <N/M> indique l'entier inférieur suivant, dans le cas où N/M n'est pas un nombre entier,

que le démultiplexeur d'entrée distribue les échantillons du signal d'entrée, fournis à la fréquence d'échantillonnage fA, de façon cyclique sur des chaînes successives μ = 0, 1, ... M-1, 0, 1, ..., de manière que la suite d'échantillons du signal d'entrée soit divisée en M suites partielles dont la cadence d'échantillonnage est réduite à fA/M,

que les différents échantillons des M suites partielles sont multipliés par des coefficients $h(\sqrt{})$ où $\sqrt{} = 0$, 1, ... N-1, de sorte qu'il se forme, pour la μ-ième suite partielle, les produits suivants:

$$P(\mu) = s\mu(kM - \sqrt{}M) \cdot h(\mu + \sqrt{}M), \quad \sqrt{} = 0, 1, 2,...,$$

que les produits P(μ, M) sont chaque fois rassemblés en signaux intermédiaires complexes $\underline{v}(kM,q)$ de manière qu'il se forme L signaux sommes qui contiennent les différents termes de somme P(μ) pour μ = pM + p · λ + q - ∞ M, un "Integer Division" (partie en nombre entier du résultat de la division) ∞ = (pM + p · λ + q) /M (figure 7) etλ = L-M et

que les signaux intermédiaires complexes $\underline{v}(kM,q)$ sont multipliés chacun, avant la transformée de Fourier discrète, par des coefficients complexes $e^{j\pi nq/L}$ (= 1 pour n = 0).

2. Banc de filtrage numérique selon la revendication 1 pour M = L/R, avec R ≦ L, R = 1, 2, 3, ..., <u>caractérisé</u> <u>en ce</u> qu'avec les produits fournis par chaque suite partielle, sont réalisées chaque fois R sommations, le premier terme de sommation réunissant le premier produit (R + 1)., (2R + 1) ... en v(kM,μ), le deuxième terme de sommation réunissant le deuxième produit (R + 2)., (2R + 2)... en v(kM, μ + L/R) et le R-ième terme de sommation réunissant le R-ième produit, le 2R-ième produit, le 3R-ième produit, et ainsi de suite en v(kM, (R-1) · L/R).

3. Banc de filtrage numérique selon la revendication 1 pour M = L, <u>caractérisé en ce</u> que pour chacune des M suites partielles, tous les produits P(μ) = P(q) sont additionnés pour former les L sommes de produits v(kM,q) pour la partie réelle et la partie imaginaire de v(kM,q).

4. Banc de filtrage numérique selon une des revendications précédentes, <u>caractérisé en ce que</u> plusieurs bancs de filtrage numériques sont disposés les uns à la suite des autres dans une structure arborescente en se ramifiant étage par étage, dans laquelle, partant du premier étage (sommet de l'arbre), une séparation en $L_\sqrt{}$ signaux élémentaires s'effectue dans le $\sqrt{}$-ième étage ($\sqrt{} = 1, 2,...$), la cadence d'échantillonnage étant diminuée chaque fois du facteur $M_\sqrt{} \leqq L_\sqrt{}$ dans le $\sqrt{}$-ième étage.

5. Banc de filtrage numérique selon une des revendications précédentes, <u>caractérisé en ce</u> que le signal d'entrée complexe du banc de filtrage numérique est dérivé, à l'aide d'un filtre à coefficients complexes, d'un signal multiplexé en fréquence qui est réel et est échantillonné à la fréquence d'échantillonnage double ($2f_A$).

6. Banc de filtrage numérique selon la revendication 1 ou 2 avec L = 4, M = 2, m = 2 et n = 1, N = 8μ-1 (μ = 1, 2, 3,...), pour des fréquences de canaux fl = 1 · B + B/2, <u>caractérisé en ce</u> que la partie réelle et la partie imaginaire du signal d'entrée complexe $\underline{s}(kT)$ sont appliquées chaque fois, au moyen d'un inverseur commuté à la fréquence d'échantillonnage fA = 1/T, à un premier instant, à une première chaîne de (N-1)/2 éléments de retard, produisant le temps de retard 2T et, à un deuxième instant, à un élément de retard de la longueur T(N-3)/2,

que les échantillons d'entrée des premier, troisième, cinquième, septième et ainsi de suite éléments de retard de la première chaîne, comportant les éléments produisant un temps de retard 2T, sont multipliés par les coefficients h(4i), i = 0, 1, 2,..., coefficients qui sont cadrés par le facteur √2, et sont réunis respectivement dans la branche de la partie réelle et dans la branche de la partie imaginaire pour former les sommes de produits vr(o) et vi(o) respectivement, tandis que les échantillons d'entrée des deuxième, quatrième, sixième, huitième, et ainsi de suite éléments de retard sont multipliés par les coefficients h(4i + 2), i = 0, 1, 2,..., coefficients qui sont cadrés par le facteur √2, et sont réunis respectivement dans la branche de la partie réelle et la branche de la partie imaginaire pour former les sommes de produits vi(2) et -vr(2) respectivement, du fait que le premier et le deuxième produit, le cinquième et le sixième produit, et ainsi de suite, sont chaque fois pondérés positivement et que le troisième et quatrième produit, le septième et huitième produit, et ainsi de suite, sont chaque fois pondérés négativement,

que la deuxième suite partielle est multipliée chaque fois à la sortie des T(N-3)/2 éléments de retard par $h(\frac{N-1}{2}) = 1/2$,

que la somme des deux produits est formée ensuite pour obtenir vi(3), de même que la différence du produit provenant de la partie réelle moins le produit provenant de la partie imaginaire, pour obtenir vr(3), avec application au processeur TFD, en tant que signaux complexes, de vr(0) avec vi(0), -vr(2) avec vi(2) et vr(3) avec vi(3) et

que le processeur TFD forme, à partir des trois signaux d'entrée complexes, quatre signaux de sortie complexes $\underline{s0}$(2k)... $\underline{s3}$(2k) de manière que

sOr(2k) = vr(0) + vr(2) + vr(3)
sOi(2k) = vi(0) + vi(2) + vi(3)
s1r(2k) = vr(0) - vr(2) + vi(3)
s1i(2k) = vi(0) - vi(2) - vr(3)
s2r(2k) = vr(0) + vr(2) - vr(3)
s2i(2k) = vi(0) + vi(2) - vi(3)
s3r(2k) = vr(0) - vr(2) - vi(3) et
s3i(2k) = vi(0) - vi(2) + vr(3).

7. Banc de filtrage numérique selon la revendication 1 ou 2, avec L = 4, M = 2, m = 2 et n = 1, N = 8μ+3 (μ = 1, 2, 3,...), pour des fréquences de canaux fl = 1 B + B/2, caractérisé en ce que la partie réelle et la partie imaginaire du signal d'entrée complexe $\underline{s}$(kT) sont appliquées chaque fois, au moyen d'un inverseur commuté à la fréquence d'échantillonnage fA = 1/T, à un premier instant, à une première chaîne de (N-1)/2 éléments de retard, produisant le temps de retard 2T et, à un deuxième instant, à un élément de retard de la longueur T(N-3)/2,

que les échantillons d'entrée des premier, troisième, cinquième, septième et ainsi de suite éléments de retard de la première chaîne, comportant les éléments produisant un temps de retard 2T, sont multipliés par les coefficients h(4i), i = 0, 1, 2,..., coefficients qui sont cadrés par le facteur √2, et sont réunis respectivement dans la branche de la partie réelle et dans la branche de la partie imaginaire pour former les sommes de produits vr(o) et vi(o) respectivement, tandis que les échantillons d'entrée des deuxième, quatrième, sixième, huitième, et ainsi de suite éléments de retard sont multipliés par les coefficients h(4i + 2), i = 0, 1, 2,..., coefficients qui sont cadrés par le facteur √2, et sont réunis respectivement dans la branche de la partie réelle et la branche de la partie imaginaire pour former les sommes de produits vi(2) et -vr(2) respectivement, du fait que le premier et le deuxième produit, le cinquième et le sixième produit, et ainsi de suite, sont chaque fois pondérés positivement et que le troisième et quatrième produit, le septième et huitième produit, et ainsi de suite, sont chaque fois pondérés négativement,

que la deuxième suite partielle est multipliée chaque fois à la sortie des T(N-3)/2 éléments de retard par

$h(\frac{N-1}{2}) = 1/2$,

que la somme des deux produits est formée ensuite pour obtenir -vi(1), de même que la différence du produit provenant de la partie réelle moins le produit provenant de la partie imaginaire, pour obtenir -vr(1), avec application au processeur TFD, en tant que signaux complexes, de vr(0) avec vi(0), -vr(1) avec vi(1) et -vr(2) avec vi(2) et

que le processeur TFD forme, à partir des trois signaux d'entrée complexes, quatre signaux de sortie complexes $\underline{s0}$(2k)... $\underline{s3}$(2k) de manière que

sOr(2k) = vr(0) + vr(1) + vr(2)
sOi(2k) = vi(0) + vi(1) + vi(2)
s1r(2k) = vr(0) - vi(1) - vr(2)
s1i(2k) = vi(0) + vr(1) - vi(2)
s2r(2k) = vr(0) - vi(i) + vi(2)
s2i(2k) = vi(0) - vi(1) + vi(2)
s3r(2k) = vr(0) - vi(1) - vr(2) et
s3i(2k) = vi(0) - vr(1) - vi(2).

8. Banc de filtrage numérique pour la réunion, dans le domaine des fréquences (réalisation d'un multiplexage en fréquence), de tout au plus L signaux élémentaires de la largeur de bande B, échantillonnés à la fréquence d'échantillonnage fA/M (M ≦ L), caractérisé en ce

qu'il est formé par un banc de filtrage numérique selon une des revendications précédentes, dans lequel toutes les directions de circulation des signaux sont inversées, les entrées et sorties du banc de filtrage sont interverties, les additionneurs sont remplacés par des points de ramification et les points de ramification sont remplacés par des additionneurs et la transformée de Fourier discrète (TFD) est remplacée par la transformée de Fourier discrète inverse, la diminution de la fréquence d'échantillonnage fA du facteur M (↓M) étant remplacée par l'augmentation de la fréquence d'échantillonnage fA/M du facteur M(↑M) et toutes les fonctions de commutation pour le démultiplexage étant remplacées par des fonctions de commutation pour le multiplexage (transposition de réseaux numériques).

# FIG. 1

$\underline{s}(kT)$

$T = \dfrac{1}{f_A}$

$f_A = L \cdot B$

Verarbeitung $\downarrow$ M$\leq$L

$\overset{\vee}{v_r}(0)$   $\overset{\vee}{v_r}(q)$   $\overset{\vee}{v_r}(L)$

Realteil

$s_r(ki)$

$s_i(kT)$

$\overset{\vee}{v_i}(0)$   $\overset{\vee}{v_i}(q)$   $\overset{\vee}{v_i}(L)$

$e^{j\pi q/L}$

$e^{j\pi(L-1)/L}$

Verarbeitung $\downarrow$ M$\leq$L

q = 0

q

q = L-1

D F T
(FFT)

l = 0

l

$\underline{s}_l(kMT)$

l = L-1

Imaginärteil

EP 0 274 474 B1

FIG. 2

FDM — $2f_A$ — DAF — $f_A = 1/T$ — $\underline{s}(kT)$ — Di Fi Ba — DFT / FFT — Dem ... Dem — 0 ... L-1 Kanal-Nr.

FIG. 3

$s_r(kT)$
(od. $s_i(kT)$)

T  T  T  T  T  T  T  T  T

MT

$h(0)$ $h(1)$ $h(2)$ $h(3)$ $h(4)$ ... $h(N-1)$

$v_r(kM,0)$    $v_r(kM,1)$    $v_r(kM,2)$    $v_r(kM,3) =$ $v_r(kM,L-1)$

FIG. 4a

$s_r$

$B$

$l = 0$ 1 2 3 4 5 6 7 8 9 10 11 12 13 14 15 $f_A$     $2f_A$   f

FIG. 4b

$|H_{DAF}(e^{j2\pi f/f_A})|$

$2f_A/4$     $2f_A$   f

FIG. 4c

$s(e^{j2\pi f/f_A})$

$l = 0$ 1 2 3 4 5 6 7 8 9 10 11 12 13 14 15 $f_A$   f

FIG. 4d

$|H_{prot}(e^{j2\pi f/f_A})|$

$\vdash B \dashv B \vdash B \dashv$     $f_A$   f

FIG. 4e

$|\underline{H}_l(e^{j2\pi f/f_A})|$, z.B. $l=7$: Frequenzgang von $|H_{prot}|$ verschoben durch komplexe Modulation mit $e^{j2\pi f_m/f_A} = e^{j2\pi l B/f_A}$ $= e^{j2\pi l/L}$    ($f_A = L \cdot B$)

$f_l$     $f_A$   f

FIG. 4f

$\underline{s}_7(e^{j2\pi f/f_A})$

$f_A$   f

FIG. 4g

$\underline{s}_7(e^{j2\pi Lf/2f_A})$, Frequenzlage von Kanälen mit ungerader Nummer

$\dfrac{f_A}{L/2}$    $\dfrac{3f_A}{L/2}$   $\dfrac{4f_A}{L/2}$     $f_A$   f

FIG. 4h

$\underline{s}_8(e^{j2\pi Lf/2f_A})$

$\dfrac{f_A}{L/2}$   $\dfrac{2f_A}{L/2}$     $f_A$   f

EP 0 274 474 B1

FIG. 5

FIG. 6

FIG. 7

**FIG. 8**

$\underline{s}_{L-1}(2L_0 kT)$

$\underline{s}_{L-2}(2L_0 kT)$

$\underline{s}_1(2L_0 kT)$

$\underline{s}_1(2L_0 kT)$

$\underline{s}_0(2L_0 kT)$

$\dfrac{1}{64} f_{si} = f$

$\underline{H}_H$   $\underline{H}_L$

$(-1)^k$

$\dfrac{1}{32} f_{si}$

$\underline{H}_H$   $\underline{H}_L$

$(-1)^k$

$\dfrac{1}{16} f_{si}$

$\underline{H}_H$   $\underline{H}_L$

$(-1)^k$

$\dfrac{1}{8} f_{si}$

$\underline{s}_{HI}$   $\underline{H}_H$   $\underline{H}_L$   $\underline{s}_{LI}$

$(-1)^k$

$\dfrac{1}{4} f_{si}$

$\underline{H}_H$   $\underline{H}_L$

$\underline{s}_0$

$e^{-jk\frac{\pi}{2}} \left( f_0 = \dfrac{1}{4} \dfrac{f_{si}}{2} \right)$

$\dfrac{1}{2} f_{si}$

DAF

$\underline{S}_0$

$s_0(kT)$

$T = 1/f_{si}$

$f_{si}$

20

FIG. 9